# EUROPEAN PATENT APPLICATION

(11) **EP 4 661 078 A1**
(43) Date of publication of application: **10.12.2025**
(21) Application number: 23920935.6
(22) Date of filing: 26.12.2023
(51) Int. Cl.: H01L 23/367

(54) **HEAT DISSIPATION PLATE AND ELECTRONIC DEVICE**

(30) Priority: 06.02.2023 CN 202310128666
(71) Applicant: REALME MOBILE TELECOMMUNICATIONS (SHENZHEN) CO., LTD., Shenzhen, Guangdong 518052 (CN)
(72) Inventor: PENG, Zhiyong, Shenzhen, Guangdong 518052 (CN); ZHANG, Xianhua, Shenzhen, Guangdong 518052 (CN)
(74) Representative: Novagraaf Technologies
(86) International application number: PCT/CN2023/141854
(87) International publication number: WO 2024/164746

(57) **Abstract**

The present application provides an electronic device. The electronic device comprises a heat source apparatus and a heat dissipation plate. The heat dissipation plate comprises a first area and a second area, wherein the first area is an area corresponding to the projection of the heat source apparatus on the heat dissipation plate, the second area is an area other than the first area, a through groove is formed in the second area, and the through groove at least partially surrounds the first area. The heat dissipation plate further comprises a conductive member, and the conductive member is at least electrically connected to two sides of part of the area of the through groove. The present application further provides the heat dissipation plate. The present application can effectively block heat conducted to the first area by the heat source device from continuing to be conducted in certain directions, thereby preventing heat from being conducted in certain undesired directions, and effectively guarantying the overall conductive integrity of the heat dissipation plate.

## Description

This application claims priority to the Chinese patent application No. 202310128666.4 filed on February 6, 2023 in the National Intellectual Property Administration of China and entitled "HEAT DISSIPATION PLATE AND ELECTRONIC DEVICE".

### TECHNICAL FIELD

The present disclosure relates to the technical field of mobile terminals, and in particular to a heat dissipation plate and an electronic device having the heat dissipation plate.

### BACKGROUND

At present, electronic devices, such as smartphones, are experiencing performance growth. While processors like SoC (System on Chip) continue to achieve higher frequencies, more cores, and increasingly powerful performance, these advancements also result in increased heat generation. Furthermore, as the electronic devices become incorporate more functionalities and the number of related functional components is increased, the heat generated by these functional components often leads to an overheating of housings of the electronic devices or is often transferred to areas where excessive temperatures are undesirable. This leads to issues such as a burning sensation or other issues, thereby resulting in poor user experience and shortened lifespans of the electronic devices.

### SUMMARY

Some embodiments of the present disclosure may provide a heat dissipation plate and an electronic device to solve the above problems.

In a first aspect, an electronic device is provided. The electronic device includes a heat source device and a heat dissipation plate. The heat dissipation plate includes a first region and a second region. The first region is a region corresponding to a projection of the heat source device onto the heat dissipation plate. The second region is a region outside the first region. A through slot is defined in the second region, the through slot at least partially surrounds the first region. The heat dissipation plate further includes one or more conductive members, each of the one or more conductive members is at least electrically connected to both sides of a partial region of the through slot.

In a second aspect, a heat dissipation plate for an electronic device is provided. The heat dissipation plate includes a first region and a second region. The first region is a region corresponding to a projection of a heat source device of the electronic device onto the heat dissipation plate. The second region is a region outside the first region. A through slot is defined in the second region, and the through slot at least partially surrounds the first region. The heat dissipation plate further includes one or more conductive members, and each of the one or more conductive members is at least electrically connected to both sides of a partial region of the through slot.

In a third aspect, another electronic device is provided. The electronic device includes an antenna, a heat source device, and a heat dissipation plate. The heat dissipation plate includes a first region and a second region. The first region is a region corresponding to a projection of the heat source device onto the heat dissipation plate. The second region is a region outside the first region. A through slot is defined in the second region. The through slot at least partially surrounds the first region and is located between the antenna and the first region.

In some embodiments of the present disclosure, by defining the through slot in the second region and configuring the through slot to at least partially surround the first region, heat conducted from the heat source device to the first region may be effectively blocked from continuing to conduct in certain directions. This may reduce the possibility of heat conduction towards certain directions where conduction is undesirable, for example, avoiding or reducing heat conduction to the housing of the electronic device, thereby reducing the occurrence of issues such as a burning sensation. Furthermore, in some embodiments of the present disclosure, by adding the conductive member to be at least electrically connected to both sides of the partial region of the through slot, the overall electrical conductivity integrity of the heat dissipation plate may be effectively ensured.

### BRIEF DESCRIPTION OF THE DRAWINGS

To describe the technical solutions in the embodiments of the present disclosure or in the related art more clearly, the following will briefly introduce the drawings required for describing the embodiments of the present disclosure or the related art.

To describe the technical solutions in the embodiments of the present disclosure or in the related art more clearly, the following will briefly introduce the drawings required for describing the embodiments of the present disclosure or the related art.
FIG. 1 is a schematic side view illustrating a partial internal structure of an electronic device according to some embodiments of the present disclosure.
FIG. 2 is a schematic plan view illustrating the partial internal structure of the electronic device according to some embodiments of the present disclosure.
FIG. 3 is another schematic plan view illustrating the partial internal structure of the electronic device according to some embodiments of the present disclosure.
FIG. 4 is yet another schematic plan view illustrating the partial internal structure of the electronic device according to some embodiments of the present disclosure.
FIG. 5 is a schematic side view illustrating the partial internal structure of a specific example of the electronic device according to some embodiments of the present disclosure.
FIG. 6 is a schematic plan view illustrating the partial internal structure of the specific example of the electronic device according to some embodiments of the present disclosure.
FIG. 7 is another schematic side view illustrating the partial internal structure of a specific example of the electronic device according to some embodiments of the present disclosure.
FIG. 8 is a further schematic plan view illustrating the partial internal structure of the electronic device according to some embodiments of the present disclosure.
FIG. 9 is another schematic plan view illustrating the partial internal structure of the electronic device according to some embodiments of the present disclosure.
FIG. 10 is a schematic plan view illustrating the partial internal structure of the electronic device according to other embodiments of the present disclosure.

### DETAILED DESCRIPTION

The technical solutions in the embodiments of the present disclosure will be described clearly and completely below with reference to the accompanying drawings in the embodiments of the present disclosure. It is apparent that the described embodiments are only a part of the embodiments of the present disclosure, rather than all of them. Based on the embodiments in the present disclosure, all other embodiments obtained by those skilled in the art without creative efforts shall fall within the protection scope of the present disclosure.

In the description of the embodiments of the present disclosure, it should be understood that terms such as "upper", "lower", "thickness", "width", etc., indicating orientations or positional relationships are based on the orientations or positional relationships shown in the drawings. These terms are merely for convenience in describing the present disclosure and simplifying the description, and do not imply or indicate that the referred device or element must have a specific orientation, or be constructed and operated in a specific orientation. Therefore, they should not be construed as limiting the present disclosure. The term "connection" in the present disclosure, unless otherwise specified, mainly refers to physical structural connection. Where specified, it may also include meanings such as electrical connection, direct connection, indirect connection, etc. **In** the description of the embodiments of the present disclosure, terms such as "first", "second", etc., are not specific designations but are used to distinguish objects with the same name. Where the description specifies, objects referred to by terms such as "first", "second", etc., with the same name may be the same object.

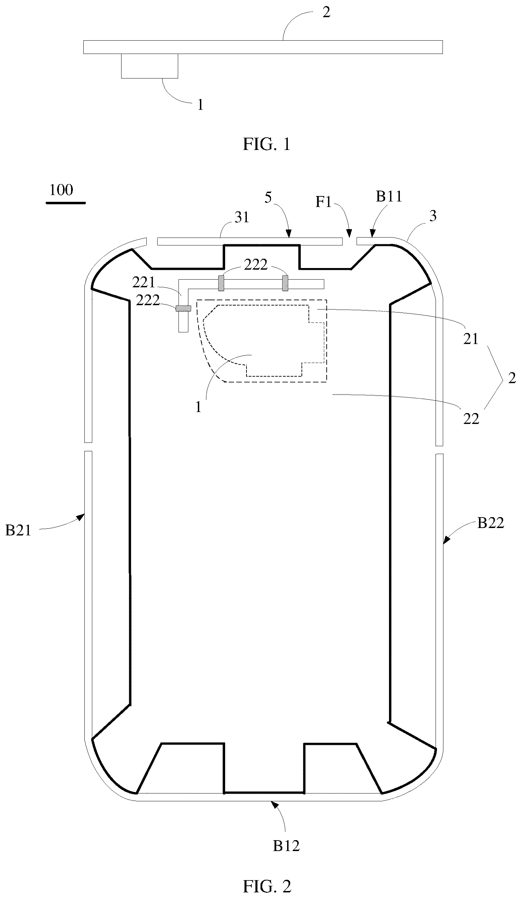

FIG. 1 is a schematic side view illustrating a partial internal structure of an electronic device 100 according to some embodiments of the present disclosure. FIG. 2 is a schematic plan view illustrating the partial internal structure of the electronic device according to some embodiments of the present disclosure. As shown in FIG. 1 and FIG. 2, the electronic device 100 may include a heat source device 1 and a heat dissipation plate 2. The heat dissipation plate 2 may have a first region 21 and a second region 22. The first region 21 may be a region corresponding to a projection of the heat source device 1 onto the heat dissipation plate 2. The second region 22 may be the region outside the first region 21. A through slot 221 may be defined in the second region 22. The through slot 221 may at least partially surround the first region 21. The heat dissipation plate 2 may further include a conductive member 222. The conductive member 222 may be at least electrically connected to both sides of a partial region of the through slot 221.

In some embodiments, the first region 21 may be the region corresponding to the projection of the heat source device 1 onto the heat dissipation plate 2. The heat source device 1 may directly abut against the heat dissipation plate 2 or indirectly abut against the heat dissipation plate 2 through other structures. Thus, the first region 21 may contact or be adjacent to the heat source device 1. Heat generated by the heat source device 1 may often be transferred to or conducted to the heat dissipation plate 2 and then conducted to a housing of the electronic device through the heat dissipation plate 2. In some embodiments of the present disclosure, by defining the through slot 221 in the second region 22 and configuring the through slot 221 to at least partially surround the first region 21, heat conducted from the heat source device 1 to the first region 21 may be effectively blocked from continuing to conduct in certain directions. This may reduce the possibility of heat conduction towards certain directions where conduction is undesirable, for example, avoiding or reducing heat conduction to the housing of the electronic device, thereby reducing the occurrence of issues such as a burning sensation. Furthermore, in some embodiments of the present disclosure, by adding the conductive member 222 to be at least electrically connected to both sides of the partial region of the through slot 221, the overall electrical conductivity integrity of the heat dissipation plate 2 may be effectively ensured.

In some embodiments, the through slot 221 may be defined and extend along at least one side of the first region 21. The conductive member 222 may cooperate with the through slot 221 to form a structure with a low thermal conductivity and a high electrical conductivity, to block heat transmitted from the heat source device 1 to the first region 21 from being transmitted towards the at least one side, and to effectively ensure the overall electrical conductivity integrity of the heat dissipation plate 2.

Consequently, since the conductive member 222 cooperates with the through slot 221 to form a structure with a low thermal conductivity and a high electrical conductivity, it may effectively block the heat transmitted from the heat source device 1 to the first region 21 from continuing to be transmitted towards the side where the through slot 221 is located, and may ensure the electrical conductivity integrity of the entire heat dissipation plate 2.

In some embodiments, the through slot 221 may be defined on at least one side of the first region 21 as needed. Thus, effective thermal blocking may be achieved in the side direction where heat propagation needs to be blocked, allowing heat to be conducted only towards other permitted sides. In this way, the direction of heat dissipation may be controlled, satisfying heat dissipation needs while reducing the occurrence of an excessive temperature on the at least one side that needs to be blocked.

FIG. 1 is a side view with the heat dissipation plate 2 positioned above. FIG. 2 is a plan view seen from a side close to the heat dissipation plate 2.

As shown in FIG. 2, the electronic device 100 may further include a bezel 3. In some embodiments, the at least one side of the first region 21 may be a side close to the bezel 3 of the electronic device 100. In this way, it is possible to reduce the occurrence of heat conducted from the heat source device 1 to the first region 21 being quickly conducted to the bezel 3 of the electronic device 100, and reducing the occurrence of the problem of an excessive temperature at certain positions on the housing of the electronic device 100. In some embodiments, the side where heat conduction is permitted or allowed may be the side of the first region 21 away from the bezel 3 of the electronic device 100.

In some embodiments, the "both sides" of the through slot 221 may refer to: the two opposite sides of the through slot 221 along the width direction of the through slot 221. The width direction of the through slot 221 may be perpendicular to an extension direction of the through slot 221. The opposite sides may refer to positions of the two opposite slot walls of the through slot 221, or portions or subregions in the second region 22 adjacent to the two opposite slot walls of the through slot 221. The "both sides of a partial region of the through slot 221" may refer to the two opposite sides of the partial region of the through slot 221 along the width direction of the through slot 221. The conductive member 222 "being at least electrically connected to both sides of a partial region of the through slot 221" means that the conductive member 222 may be electrically connected to the two opposite sides of the through slot 221 along the width direction of the through slot 221 in at least the partial region of the through slot 221.

In some embodiments, the conductive member 222 may include at least one conductive member, i.e., the number of the conductive members 222 is at least one. The at least one conductive member 222 may be arranged at intervals along the extension direction of the through slot 221. Each conductive member 222 may bridge both sides of the through slot 221 and is electrically connected to the both sides of the through slot 221. For example, as shown in FIG. 2, the conductive member 222 may include three conductive members, i.e., the number of the conductive members 222 is three. The three conductive members 222 may be arranged at intervals along the extension direction of the through slot 221. Each of the three conductive members 222 may bridge both sides of the through slot 221 and be electrically connected to both sides of the through slot 221. That is, in some embodiments, the number of the conductive members 222 may be at least one member. The dimension of each conductive member 222 along the extension direction of the through slot 221 may be smaller than the length of the through slot 221, and each conductive member 222 may be spaced apart from an adjacent conductive member. The length of the through slot 221 may be a dimension along the extension direction of the through slot 221.

Therefore, in some embodiments, the conductive member 222 may be at least electrically connected to both sides of the partial region of the through slot 221 by arranging at least one conductive member 222 at intervals along the extension direction of the through slot 221 with each conductive member 222 bridging both sides of the through slot 221 and being electrically connected to both sides of the through slot 221. The conductive member 222 may be strip-shaped, bridging both sides of the through slot 221 and being electrically connected to the both sides of the through slot 221.

In some embodiments, when at least one conductive member 222 is arranged at intervals along the extension direction of the through slot 221, each conductive member 222 may be made of a metal material or a metal alloy material. In some embodiments, the conductive member 222 may be made of a metal or metal alloy material with good electrical and thermal conductivities, or a metal or metal alloy material with a good electrical conductivity but a poor thermal conductivity.

For example, the conductive member 222 may be made of copper, aluminum, silver, or other metal materials with good electrical and thermal conductivities, or certain metal alloy materials with good electrical and thermal conductivities. Thus, since one or more conductive members 222 are arranged at intervals along the extension direction of the through slot 221, although the conductive members 222 have good electrical and thermal conductivities, most heat will still be blocked by the through slot 221. Therefore, it may still block the heat transmitted from the heat source device 1 to the first region 21 from continuing to be transmitted towards the side where the through slot 221 is located. Since the conductive members 222 have good electrical conductivity and bridge the through slot in one or more regions, the electrical conductivity of the entire heat dissipation plate 2 may be improved.

As another example, the conductive member 222 may be made of a metal alloy material such as titanium alloy, manganese alloy, etc., which has a good electrical conductivity but a poor thermal conductivity. Or in some embodiments, the conductive member 222 may be made of a metal material, such as titanium, with a good electrical conductivity but a poor thermal conductivity. In this way, by using a metal alloy or metal material with a good electrical conductivity but a poor thermal conductivity for the conductive member 222, the thermal blocking or thermal insulating performance may be further improved, better blocking heat transmitted from the heat source device 1 to the first region 21 from continuing to be transmitted towards the side where the through slot 221 is located, while also ensuring the electrical conductivity integrity of the entire heat dissipation plate 2.

In FIG. 2, the number of conductive members 222 is three, arranged at intervals along the extension direction of the through slot 221. Obviously, the number of conductive members 222 could also be one, two, four, five, six, etc.

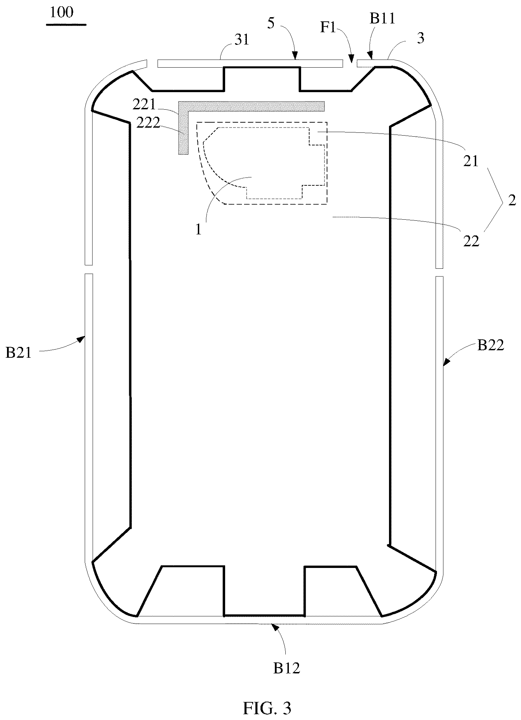

As is shown in FIG. 3, FIG. 3 is another schematic plan view illustrating the partial internal structure of the electronic device 100 according to some embodiments of the present disclosure. FIG. 3 is also a plan view seen from the side close to the heat dissipation plate 2. As shown in FIG. 3, the conductive member 222 may be filled in the through slot 221 and at least electrically connected to both sides of the partial region of the through slot 221.

That is, in some embodiments, the conductive member 222 may also be filled in the through slot 221 and at least electrically connected to the both sides of the partial region of the through slot 221.

In this way, by filling, the conductive member 222 may be at least electrically connected to both sides of the partial region of the through slot 221, enabling the conductive member 222 and the through slot 221 to cooperate to form a structure with a low thermal conductivity and a high electrical conductivity. This effectively blocks the heat transmitted from the heat source device 1 to the first region 21 from continuing to be transmitted towards the side where the through slot 221 is located, and ensures the electrical conductivity integrity of the entire heat dissipation plate 2.

In some embodiments, as shown in FIG. 3, the conductive member 222 may be completely filled in the through slot 221 and electrically connected to both sides of the through slot 221. The conductive member 222 may be made of a material with a good electrical conductivity and a poor thermal conductivity. As shown in FIG. 3, the dimension of the conductive member 222 along the extension direction of the through slot 221 may be substantially equal to the length of the through slot 221.

In any embodiment of the present disclosure, the conductive member 222 being made of "a material with a good electrical conductivity and a poor thermal conductivity" may mean that the thermal conductivity of the conductive member 222 is less than a preset thermal conductivity, and the electrical conductivity of the conductive member is greater than or equal to a preset electrical conductivity. That is, the metal alloy material with a good electrical conductivity but a poor thermal conductivity, or the metal material with a good electrical conductivity but a poor thermal conductivity mentioned in the previous embodiments, may also refer to a metal or a metal alloy material whose thermal conductivity is less than the preset thermal conductivity and whose electrical conductivity is greater than or equal to the preset electrical conductivity. In any embodiment of the present disclosure, the conductive member 222 being made of "a material with a good electrical conductivity and a poor thermal conductivity" may mean that the thermal conductivity of the conductive member 222 is greater than or equal to the preset thermal conductivity, and the electrical conductivity of the conductive member is greater than or equal to the preset electrical conductivity.

The conductive member 222 being "completely filled in the through slot 221" may mean that the conductive member 222 fills the entire through slot 221 along the extension direction of the through slot 221, i.e., the dimension of the conductive member 222 along the extension direction of the through slot 221 may be equal to the length of the through slot 221, as mentioned earlier. In this case, the conductive member 222, made of a material with a good electrical conductivity and a poor thermal conductivity, may have a thermal-insulation function and achieve a good electrical connection performance, thereby ensuring the electrical conductivity integrity of the heat dissipation plate 2.

In some embodiments, the thermal conductivity of the conductive member 222 may be less than half the thermal conductivity of aluminum. The electrical conductivity of the conductive member 222 may be greater than or equal to half the electrical conductivity of aluminum. That is, the preset thermal conductivity may be half the thermal conductivity of aluminum. The preset electrical conductivity may be half the electrical conductivity of aluminum.

In some embodiments, the thermal conductivity of aluminum is 217 W/m·K (Watts per meter-Kelvin), and the electrical conductivity of aluminum is approximately 35.33569S/m (Siemens per meter). Therefore, in some embodiments, the preset thermal conductivity may be 109 W/m·K, and the preset electrical conductivity may be 18 S/m.

Thus, by designing the thermal conductivity of the conductive member 222 to be less than half that of aluminum and the electrical conductivity of the conductive member 222 to be greater than or equal to half that of aluminum, the conductive member 222 may exhibit properties of a good electrical conductivity and a poor thermal conductivity, meeting the requirements of blocking heat transmission and ensuring the electrical conductivity integrity.

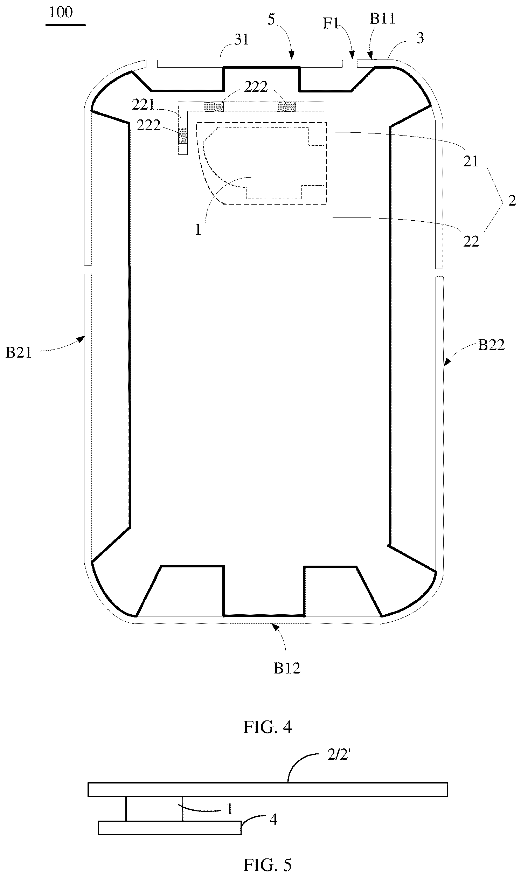

As shown in FIG. 4, FIG. 4 is yet another schematic plan view illustrating the partial internal structure of the electronic device 100 according to some embodiments of the present disclosure. FIG. 4 is also a plan view seen from the side close to the heat dissipation plate 2. As shown in FIG. 4, the conductive member 222 may be filled in a partial region of the through slot 221 and electrically connected to both sides of the partial region of the through slot 221.

In some embodiments, the number of the conductive members 222 may be at least one, and the at least one conductive member 222 may be filled at intervals in partial regions of the through slot 221. As shown in FIG. 4, the number of the conductive members 222 is three. The three conductive members 222 may be arranged at intervals along the extension direction of the through slot 221, filled in corresponding regions of the through slot 221, and electrically connected to both sides of the partial regions of the through slot 221.

That is, in some embodiments, as shown in FIG. 4, multiple conductive members 222 are filled at intervals along the extension direction of the through slot 221 within the through slot 221, and each conductive member 222 is electrically connected to both sides of the through slot 221, such that the conductive members 222 are at least electrically connected to both sides of the partial regions of the through slot 221. In some embodiments, the number of the conductive members 222 may be at least one. Each conductive member 222 may be filled in the through slot 221, the dimension of each conductive member 222 along the extension direction of the through slot 221 may be smaller than the length of the through slot 221. The each conductive member 222 may be spaced apart from an adjacent conductive member. The length of the through slot 221 may be the dimension of the through slot 221 along the extension direction of the through slot 221.

In some embodiments, when at least one conductive member 222 is filled at intervals in partial regions of the through slot 221, each conductive member 222 filled in the through slot 221 may also be made of a metal material or a metal alloy material. In some embodiments, the conductive member 222 filled in the through slot 221 may be made of a metal or metal alloy material with good electrical and thermal conductivities, or a metal or metal alloy material with a good electrical conductivity but a poor thermal conductivity.

For example, the conductive member 222 may be made of copper, aluminum, silver, or other metal materials with good electrical and thermal conductivities, or certain metal alloy materials with good electrical and thermal conductivities. Thus, despite the conductive members 222 having good electrical and thermal conductivities, most heat will still be blocked by the through slot 221 because the conductive members 222 are arranged at intervals along the extension direction of the through slot 221. Therefore, it can still block the heat transmitted from the heat source device 1 to the first region 21 from continuing to be transmitted towards the side where the through slot 221 is located. Since the conductive members 222 have good electrical conductivity and bridge the slot in at least one position, the electrical conductivity integrity of the entire heat dissipation plate 2 may be ensured, thereby ensuring the electrical conductivity integrity of the heat dissipation plate 2.

As another example, the conductive member 222 may be made of a metal alloy material such as titanium alloy or manganese alloy, which has a good electrical conductivity but a poor thermal conductivity, or a metal material such as titanium with a good electrical conductivity but a poor thermal conductivity. In this way, by using a metal alloy or metal material with a good electrical conductivity but a poor thermal conductivity for the conductive members 222, the thermal blocking or thermal insulating performance may be further improved, which may better block the heat transmitted from the heat source device 1 to the first region 21 from continuing to be transmitted towards the side where the through slot 221 is located, while also ensure the electrical conductivity integrity of the entire heat dissipation plate 2, thus ensuring the electrical conductivity integrity of the heat dissipation plate 2.

As shown in FIG. 4, the number of the conductive members 222 may be three. The conductive members 222 may be filled at intervals within the through slot 221 along the extension direction of the through slot 221. Obviously, the number of the conductive members 222 may also be one, two, four, five, six, etc.

As shown in FIGS. 2-4, the electronic device 100 may include a first short side/edge B11 and a second short side/edge B12 opposite to each other, and a first long side/edge B21 and a second long side/edge B22 opposite to each other. The at least one side of the first region 21 may include the side of the first region 21 facing the first short side B11.

In some embodiments, the first short side B11 may be the short side at the top of the electronic device 100, and the second short side B12 may be the short side at the bottom of the electronic device 100.

The orientational terms "top" and "bottom" used in describing the electronic device 100 in some embodiments of the present disclosure may be explained based on the orientations when a user holds and uses the electronic device 100. The position towards the top side of the electronic device 100 may be "top", and the position towards the bottom side may be "bottom". This does not indicate or imply that the device or element must have a specific orientation or be constructed and operated in a specific orientation, and therefore should not be construed as limiting the orientation in the actual application of the electronic device 100. In some embodiments, the bottom of the electronic device 100 may be the end defining a headphone jack, a USB port, etc. The top of the electronic device 100 may be the other end opposite to the end defining the headphone jack, the USB port, etc., or the top of the electronic device 100 may refer to the end provided with a camera, a receiver, etc.

As shown in FIGS. 2-4, the heat source device 1 may be disposed close to the top of the electronic device 100.

Therefore, without the through slot 221, since the heat source device 1 is close to the bezel 3 at the first short side B11, the heat conducted from the heat source device 1 to the first region 21 of the heat dissipation plate 2 would be quickly conducted to the corresponding bezel 3 through the heat dissipation plate 2, causing the temperature of the corresponding bezel 3 to rise rapidly, thereby resulting in a burning sensation. Thus, in some embodiments of the present disclosure, the through slot 221 may be defined and extends along at least one side of the first region 21, and the at least one side of the first region 21 may include the side of the first region 21 facing the first short side B11. That is, in some embodiments, the through slot 221 may be defined at the side including the side of the first region 21 facing the first short side B11, thereby effectively blocking the heat conduction to the bezel 3 located at the first short side B11 and reducing the occurrence of an excessive temperature on the housing of the electronic device 100.

As shown in FIGS. 2-4, the at least one side of the first region 21 may further include the side of the first region 21 facing the first long side B21. **In** this way, the heat conduction to the bezel 3 located at the first long side B21 may also be effectively blocked, thereby reducing the occurrence of an excessive temperature on the housing of the electronic device 100.

**In** some embodiments, an antenna configured to transmit and receive signals may be designed on (e.g., using the bezel as the antenna) or near the bezel 3 of the electronic device. The antenna may be generally made of metal and prone to generating heat. **In** this embodiment, the design of the through slot 221 may better reduce the conduction of the heat from the heat source device 1 to the bezel 3 or the corresponding antenna, thereby reducing the occurrence of high heat at the location of the antenna. In some embodiments, antennas may also be designed on or near other bezels. It may or may not use the through slot for thermal insulation. Taking a mobile phone as an example, the inventor found that during calls, the top bezel (e.g., the bezel 3) may be usually against the user's skin. High heat would give the user a poor experience. Additionally, during gaming in landscape orientation, the antenna position corresponding to the bezel 3 might be held, and high heat would also affect the user experience. Therefore, whether to use a through slot for thermal insulation for an antenna may be considered based on the impact of high-heat scenarios on the user during use.

In some embodiments, the antenna may be grounded through the heat dissipation plate, i.e., the heat dissipation plate may serve as the system ground for the antenna of the electronic device. The heat dissipation plate may be configured to be connected to the antenna so that the antenna may be grounded. Therefore, after defining the through slot, the design of the conductive member is needed to ensure the grounding performance of the antenna, thereby ensuring the performance of the antenna. The design of the conductive member may refer to the examples in the relevant embodiments of the present disclosure.

For example, in the embodiments shown in FIG. 2, when there are three conductive members 222 bridging the through slot 221, two of them may be located in the region of the through slot 221 at the side of the first region 21 facing the first short side B11, and one conductive member 222 may be located in the region of the through slot 221 at the side of the first region 21 facing the first long side B21. The three conductive members 222 may be spaced apart as much as possible, thereby improving the electrical conductivity integrity of the heat dissipation plate 2.

For example, in the embodiments shown in FIG. 4, when there are three conductive members 222 filling the through slot 221, two of them may be filled in the region of the through slot 221 at the side of the first region 21 facing the first short side B11, and one conductive member 222 may be filled in the region of the through slot 221 at the side of the first region 21 facing the first long side B21. The three conductive members 222 may be spaced apart as much as possible, thereby improving the electrical conductivity integrity of the heat dissipation plate 2.

Obviously, the at least one side of the first region 21 may further include the side of the first region 21 facing the second long side B22. In this way, the heat conduction to the bezel 3 located at the second long side B22 may also be effectively blocked, thereby reducing the occurrence of an excessive temperature on the housing of the electronic device 100.

In some embodiments of the present disclosure, the through slot 221 extending along at least one side of the first region 21 may mean that the through slot 221 extends substantially along the length direction of the bezel 3 corresponding to the at least one side of the first region 21. The through slot 221 extending along at least one side of the first region 21 may include the case where the through slot 221 completely extends past or over the side of the first region 21, i.e., the projection of the first region 21 along/on that side may be completely within the through slot 221. It may also include the case where the through slot 221 only partially extends past that side of the first region 21, i.e., at least part of the projection of the first region 21 on that side may be outside the through slot 221.

As mentioned earlier, the heat source device 1 may be disposed close to the top of the electronic device 100. Therefore, there may be some space between the heat source device 1 and the second short side B12 of the electronic device 100, i.e., the bottom of the electronic device 100. In some embodiments of the present disclosure, the through slot 221 extends along at least one side of the first region 21, and the at least one side may include the side of the first region 21 facing the first short side B11, or may further include the sides facing the first long side B21 and the second long side B22, while no through slot 221 is defined on the side of the first region 21 facing the second short side B12. In this way, the heat generated by the heat source device 1 located on a mainboard 4 will be gradually dissipated into the space between the heat source device 1 and the second short side B12, and then slowly dissipated to the housing of the electronic device 100. Consequently, the temperature of the housing of the electronic device 100 will not rise rapidly, ensuring the heat dissipation needs of the heat source device 1 and reducing the occurrence of the problem of the burning sensation caused by an excessive temperature on the housing.

The heat dissipation plate 2 may be made of a metal or metal alloy material with good electrical and thermal conductivities. That is, the thermal conductivity of the heat dissipation plate 2 may be greater than or equal to the preset thermal conductivity, and the electrical conductivity of the heat dissipation plate 2 may be greater than or equal to a preset electrical conductivity.

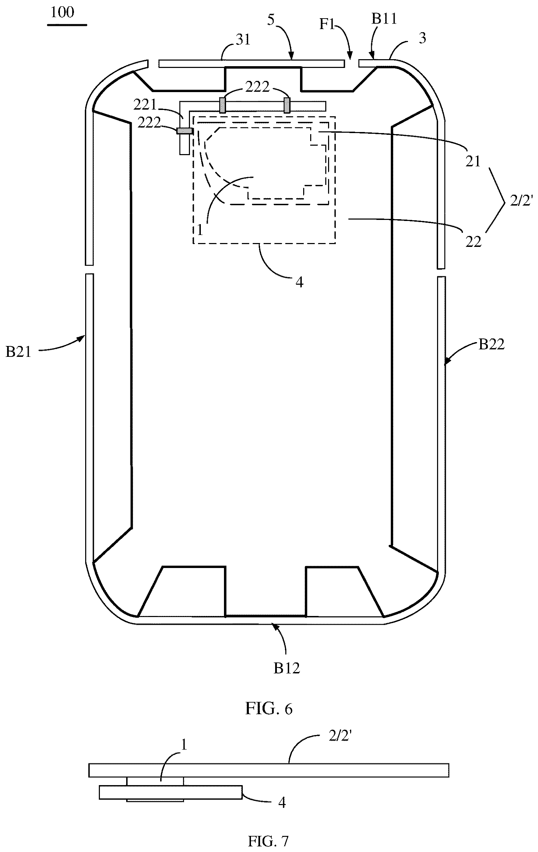

As shown in FIG. 5 and FIG. 6 together, FIG. 5 is a schematic side view illustrating the partial internal structure of a specific example of the electronic device 100 according to some embodiments of the present disclosure. FIG. 6 is a schematic plan view illustrating the partial internal structure of a specific example of the electronic device according to some embodiments of the present disclosure.

In some embodiments, the electronic device 100 may further include the mainboard 4. The heat dissipation plate 2 may be a middle frame 2'. The heat source device 1 may be disposed on the mainboard 4. The heat dissipation plate 2 / middle frame 2' may be arranged substantially parallel to the mainboard 4.

The middle frame 2' may be a supporting frame of the electronic device 100. Components such as the mainboard 4 with the heat source device 1 may be ultimately carried and fixed within the electronic device 100 by the middle frame 2'. Therefore, the first region 21 of the middle frame 2' may directly abut against the functional device/heat source device 1 to contact the heat source device 1 or may be adjacent to the heat source device 1 through other structures with a certain gap therebetween. At least part of an edge of the middle frame 2' may be also connected to the bezel 3 of the electronic device 100. Consequently, the first region 21 of the middle frame 2' may contact or be close to or adjacent to the heat source device 1. The heat generated by the heat source device 1 may be often conducted to the middle frame 2' and then conducted to the housing of the electronic device, such as the bezel. Thus, in some embodiments of the present disclosure, by defining the through slot 221 in the second region and the through slot 221 at least partially surrounding the first region 21, the heat conducted from the heat source device 1 to the first region 21 may be effectively blocked from continuing to be conducted in certain directions, thereby reducing the heat conducted to the housing of the electronic device and reducing the occurrence of the issues such as the burning sensation. Furthermore, since the middle frame 2' generally serves as the system ground for antennas, in some embodiments of the present disclosure, by adding the conductive member 222 to be at least electrically connected to both sides of a partial region of the through slot 221, the electrical conductivity integrity of the middle frame 2' may be effectively ensured. In this way, the integrity of the system ground may be guaranteed, reducing the possibility of lengthening a current return path of an antenna and ensuring antenna performance.

In some embodiments of the present disclosure, the middle frame 2' being arranged parallel to the mainboard 4 does not means that the middle frame 2' is strictly parallel to the mainboard 4, but means the heat dissipation plate 2 and the mainboard 4 may be substantially parallel to each other, allowing for angular deviations, for example, allowing deviations of ±10 degrees.

The perspective of FIG. 5 is a side view with the back of the electronic device 100 facing up. The perspective of FIG. 6 is a plan view seen from the back of the electronic device 100. The back of the electronic device 100 may be the side of the electronic device 100 opposite to a display screen.

As shown in FIG. 6, at least part of the edge of the middle frame 2' may be connected to the corresponding bezel 3. Therefore, without the through slot 221, the heat conducted from the functional device/heat source device 1 to the first region 21 of the middle frame 2' would be conducted to the corresponding bezel 3 through the heat dissipation plate 2, causing a significant increase in the temperature of the corresponding bezel 3 and resulting in a burning sensation. Thus, by extending the through slot 221 along the side of the first region 21 close to the bezel 3 of the electronic device 100, the heat conduction to the bezel 3 may be effectively blocked, thereby reducing the occurrence of an excessive temperature on the housing of the electronic device 100.

In FIGS. 2-4, FIG. 6, etc., the overall frame formed by thicker lines represents the heat dissipation plate 2 / middle frame 2'. As shown in FIG. 6, the middle frame 2' may be at least connected to the bezel 3 at the first short side B11. Therefore, without the through slot 221, since the functional device/heat source device 1 is close to the bezel 3 at the first short side B11, the heat conducted from the functional device/heat source device 1 to the first region 21 of the heat dissipation plate 2 would be quickly conducted to the corresponding bezel 3 through the heat dissipation plate 2, thereby causing the temperature of the bezel 3 to rise rapidly and resulting in a burning sensation. Thus, in some embodiments of the present disclosure, the through slot 221 extends along at least one side of the first region 21, and the at least one side may include the side of the first region 21 facing the first short side B11. That is, in some embodiments, the through slot 221 may be formed on the side including the side of the first region 21 facing the first short side B11, thereby effectively blocking heat conduction to the bezel 3 located at the first short side B11 and reducing the occurrence of an excessive temperature on the housing of the electronic device 100.

As shown in FIG. 6, the dimension of the mainboard 4 along the first long side B21 and the second long side B22 may be often significantly smaller than the length of the first long side B21 and the second long side B22. The mainboard 4 may be disposed close to the top of the electronic device 100. Thus, the heat source device 1 disposed on the mainboard 4 may be also located close to the top of the electronic device 100. Therefore, there is space between the mainboard 4 and the second short side B12 of the electronic device 100, i.e., the bottom of the electronic device 100. In some embodiments of the present disclosure, the through slot 221 extends along at least one side of the first region 21, and the at least one side may include the side of the first region 21 facing the first short side B11, or may further include the sides facing the first long side B21 and the second long side B22, while no through slot 221 is defined on the side of the first region 21 facing the second short side B12 (i.e., the side away from the bezel 3, as mentioned earlier). In this way, the heat generated by the heat source device 1 located on the mainboard 4 may be gradually dissipated into the space between the mainboard 4 and the second short side B12, and then slowly dissipated to the housing of the electronic device 100. Consequently, the temperature of the housing of the electronic device 100 will not rise rapidly, ensuring the heat dissipation needs of the heat source device 1 and reducing the occurrence of the problem of the burning sensation caused by an excessive temperature of the housing.

As shown in FIG. 6, in some embodiments, the heat source device 1 may be disposed on a surface 11 of the mainboard 4 facing the middle frame 2'. In this way, the heat source device 1 may protrude towards the middle frame 2', abut against and contact the middle frame 2', or may be disposed adjacent to the middle frame 2', and will conduct the generated heat to the middle frame 2'.

As shown in FIG. 7, FIG. 7 is another schematic side view illustrating the partial internal structure of the electronic device 100 according to some embodiments of the present disclosure. As shown in FIG. 7, the mainboard 4 may define a receiving hole (not shown). The heat source device 1 may be embedded in the receiving hole, and at least part of the heat source device 1 may protrude from the mainboard 4 towards the middle frame 2'.

Thus, in other examples, embedding the heat source device 1 in the receiving hole may effectively reduce the overall thickness of the mainboard 4 with the heat source device 1, reducing the volume and facilitating miniaturization of the electronic device 100.

FIGS. 5-7 illustrate only some examples which take the middle frame 2' as the heat dissipation plate 2 and in which the heat source device 1 is disposed on the mainboard 4. FIG. 6 illustrates the conductive member 222 bridging the through slot 221. Obviously, the structure of the middle frame 2' may be the structure of the heat dissipation plate 2 in any of the foregoing embodiments, and may refer to the structure of the heat dissipation plate 2 in any embodiment of the present disclosure for details.

In some embodiments, the heat dissipation plate 2 may also be the mainboard 4, i.e., the mainboard 4 may define the through slot 221 and be arranged with the conductive members 222, etc. In other embodiments, the heat dissipation plate 2 may also have other structures, for example, the heat dissipation plate 2 may be an independently arranged heat dissipation plate.

In any embodiment of the present disclosure, the first region 21 "being the region corresponding to the projection of the heat source device 1 onto the heat dissipation plate 2" may mean that the first region 21 is the region coinciding with the projection of the heat source device 1 onto the heat dissipation plate 2. It may also mean that the first region 21 is a region including or covering the projection of the heat source device 1 onto the heat dissipation plate 2 and slightly larger than the projection of the heat source device 1 onto the heat dissipation plate 2.

Obviously, in some embodiments, the first region 21" corresponding to the region of projection of the heat source device 1 onto the heat dissipation plate 2" may also mean that the first region 21 may be slightly smaller than the projection of the heat source device 1 onto the heat dissipation plate 2 and located within the projection of the heat source device 1 onto the heat dissipation plate 2. In some embodiments, it may mean that the first region 21 partially or mostly coincides with the projection of the heat source device 1 onto the heat dissipation plate 2. Thus, part or most of the heat from the heat source device 1 can still be isolated.

In some embodiments of the present disclosure, there may be a certain interval between the through slot 221 and the first region 21, and both sides of the through slot 221 may be located in the second region 22. In some embodiments, the first region 21 may also be a hollow region, allowing at least part of the heat source device 1 to be accommodated therein, which may further reduce the overall volume. In this case, the heat source device 1 may contact or may be adjacent to the inner side of the hollow first region 21.

In some embodiments, the number of the heat source devices 1 may be at least one, i.e., there may be one or multiple heat source devices. When there are multiple heat source devices 1, the first region 21 may be a region including the projections of all heat source devices 1 onto the heat dissipation plate 2 and slightly greater than a combined region of the projections of all heat source devices 1. In some embodiments, the number of the first regions 21 may also be multiple, and the first regions 21 and the heat source devices 1 are in one-to-one correspondence. That is, each first region 21 coincides with the projection of a corresponding heat source device 1 onto the heat dissipation plate 2, or may be a region including the projection of the corresponding heat source device 1 onto the heat dissipation plate 2 and slightly greater than the projection. Obviously, similarly, when there are multiple heat source devices 1, the first region 21 may also be slightly smaller than a complete region of the projections of all heat source devices 1 onto the heat dissipation plate 2, or a complete region that partially or mostly coincides with the projections of all heat source devices 1 onto the heat dissipation plate 2. Or, when multiple first regions 21 are defined, each first region 21 may be slightly smaller than the projection of a corresponding heat source device 1 onto the heat dissipation plate 2 and located within the corresponding projection, or may be a region that partially or mostly coincides with the corresponding projection.

When multiple first regions 21 are defined, at least one side of each first region 21 may define the aforementioned through slot 221. A corresponding conductive member 222 may be also arranged, and the conductive member 222 may be configured to be at least electrically connected to both sides of a partial region of the corresponding through slot 221.

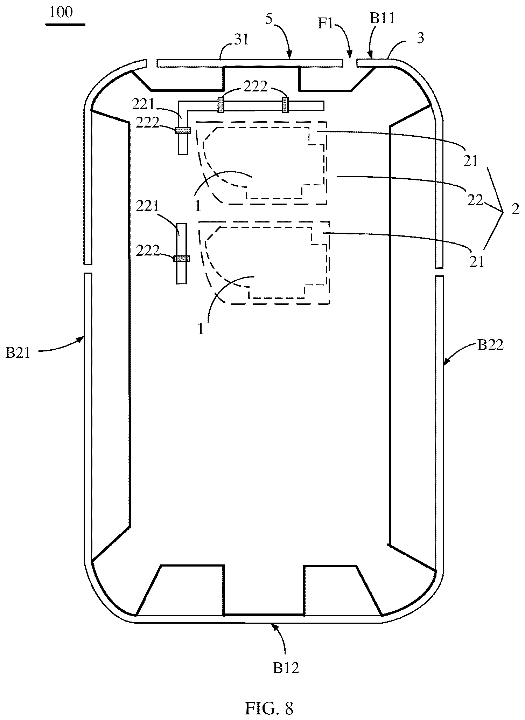

For example, as shown in FIG. 8, FIG. 8 is a further schematic plan view illustrating the partial internal structure of the electronic device 100 according to some embodiments of the present disclosure.

As shown in FIG. 8, multiple or two or more heat source devices 1 are provided, and multiple or two or more first regions 21 are defined correspondingly. Each first region 21 corresponds to one heat source device 1. That is, each first region 21 coincides with the projection of the corresponding heat source device 1 onto the heat dissipation plate 2, or may be a region including the projection of the corresponding heat source device 1 onto the heat dissipation plate 2 and slightly greater than the projection of the corresponding heat source device 1 onto the heat dissipation plate 2. In some embodiments, as shown in FIG. 8, each first region 21 may include the projection of the corresponding heat source device 1 onto the heat dissipation plate 2 and may be slightly greater than the projection of the corresponding heat source device 1 onto the heat dissipation plate 2.

As shown in FIG. 8, at least one side of each first region 21 may define the through slot 221. For different first regions 21, the sides where the through slots 221 are defined may be at least partially different from each other. For example, as shown in FIG. 8, there may be two heat source devices 1, and the two heat source devices 1 are arranged along the length direction of the first long side B21 and the second long side B22. There may also be two first regions 21. For the heat source device 1 disposed closer to the first short side B11, the corresponding through slot 221 may be defined on each of the side facing the first short side B11 and the side facing the first long side B21. For the other heat source device 1 away from the first short side B11, the corresponding through slot 221 may be defined only on the side facing the first long side B21. Thus, overall, a structure with a low thermal conductivity and a high electrical conductivity may be still defined, blocking the heat conduction towards the first short side B11 and the first long side B21, while allowing the heat generated by the two heat source devices 1 to be dissipated towards the space on the side of the second short side B12, and then slowly dissipated to the housing of the electronic device 100. Consequently, the temperature of the housing of the electronic device 100 will not rise rapidly, ensuring the heat dissipation needs of the heat source devices 1 and reducing the occurrence of the problem of the burning sensation caused by an excessive temperature on the housing of the electronic device 100.

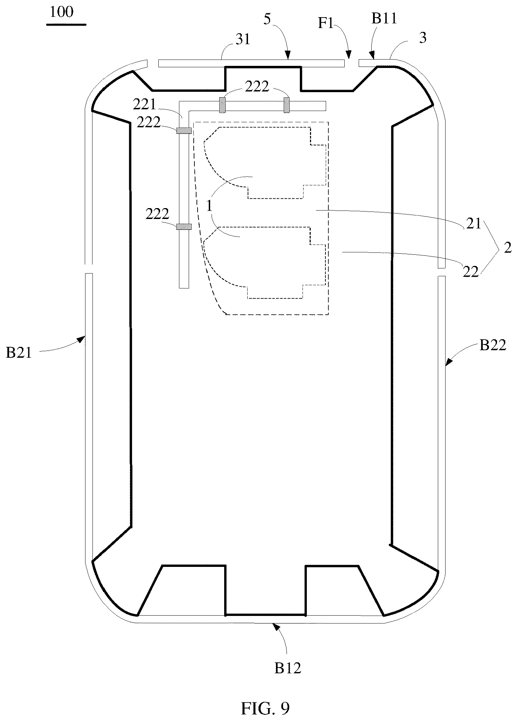

As another example, as shown in FIG. 9, FIG. 9 is another schematic plan view illustrating the partial internal structure of the electronic device 100 according to some embodiments of the present disclosure.

As shown in FIG. 9, there may be multiple heat source devices 1. The first region 21 may be a region including the projections of all heat source devices 1 onto the heat dissipation plate 2 and slightly greater than the combined region of the projections of all heat source devices 1. In this way, all heat source devices 1 may be treated as a whole when setting the through slot 221, the heat generated by all heat source devices 1 is blocked from conducting in certain directions, and the heat may be conducted only towards directions without the through slot 221. For example, the heat generated by all heat source devices 1 may be allowed to be dissipated towards the space on the side of the second short side B12, and then slowly dissipated to the housing of the electronic device 100. Consequently, the temperature of the housing of the electronic device 100 will not rise rapidly, ensuring the heat dissipation needs of the heat source devices 1 and reducing the occurrence of the problem of the burning sensation caused by an excessive temperature of the housing.

In some embodiments, when multiples heat source device 1 are disposed on the mainboard 4 and the mainboard 4 defines multiples receiving holes, the number of the receiving holes may be less than the number of the heat source devices 1. Thus, all heat source devices 1 may be embedded in the receiving holes, or some heat source devices 1 may be embedded in receiving holes while other heat source devices 1 may be mounted on the surface of the mainboard 4.

As shown in FIGS. 2-4, FIG. 7, etc., in some embodiments, the electronic device 100 may further include an antenna 5. In any embodiment of the present disclosure, the at least one side of the first region 21 may include the side facing the antenna 5. The grounding point of the antenna 5 may be electrically connected to the aforementioned heat dissipation plate 2 / middle frame 2', achieving grounding.

In some embodiments, the antenna 5 may be at least disposed at the first short side B11 of the electronic device 100. In some embodiments, the antenna 5 may be also disposed at a position on the first long side B21 close to the first short side B11. Obviously, the antenna 5 may also be disposed at a position on the second long side B22 close to the first short side B11.

Thus, by defining the through slot 221 on the side of the first region 21 facing the antenna 5, the heat generated by the heat source device 1 may be effectively blocked from be conducted to the antenna 5. Therefore, in scenarios such as making calls, issues such as user discomfort or even skin burns caused by overheating of the antenna 5 may be effectively reduced.

When the antenna 5 is disposed on multiple sides/edges of the electronic device 100, the at least one side may include the side facing the antenna 5 located on at least one side. For example, the at least one side may only include the side facing the antenna 5 located at the first short side B11, or may further include the side facing the antenna 5 located at the first long side B21.

In the present disclosure, the bezel 3 may be a metal bezel. The bezel 3 may also be divided into multiple metal segments 31 by slits F1. At least some metal segments 31 may serve as the antenna 5. The grounding point of the metal segment 31 serving as the antenna 5 may be electrically connected to the aforementioned middle frame 2', achieving grounding.

In any embodiment of the present disclosure, the through slot 221 may be a slot penetrating through two opposite surfaces of the heat dissipation plate 2. For example, when the heat dissipation plate 2 may be the middle frame 2', one of the two opposite surfaces faces the mainboard 4, and the other surface faces away from the mainboard 4.

The heat source device 1 in the present disclosure may be any device capable of generating heat, such as a processor, a battery, a codec chip, etc. The heat source device 1 may include at least one heat source device. In some embodiments, the heat source device 1 may include at least one of a processor, a battery, a codec chip, etc. When the heat source device 1 includes multiple heat source devices, the multiple heat source devices 1 may include the devices of the same type or different types.

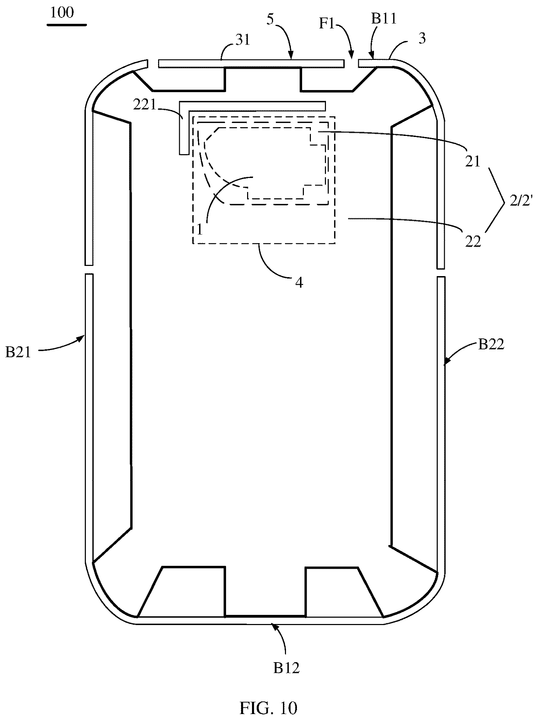

As shown in FIG. 10, FIG. 10 is a schematic plan view illustrating the partial internal structure of an electronic device 100 according to other embodiments of the present disclosure. The electronic device 100 may include a heat source device 1, a heat dissipation plate 2, and an antenna 5. The heat dissipation plate 2 may include a first region 21 and a second region 22. The first region 21 may be a region corresponding to a projection of the heat source device 1 onto the heat dissipation plate 2. The second region 22 may be the region outside the first region 21. A through slot 221 may be defined in the second region 22. The through slot 221 may at least partially surround the first region 21. The through slot 221 may be located between the antenna 5 and the first region 21.

That is, in other embodiments, the electronic device 100 may include the antenna 5, the heat source device 1, and the heat dissipation plate 2. Only the through slot 221 may be defined in the second region 22 to block the heat generated by the heat source device 1 from being conducted to the antenna 5. In this way, the heat generated by the heat source device 1 may be effectively blocked from being conducted to the antenna 5. Therefore, in scenarios such as making calls, issues such as user discomfort or skin burns caused by overheating of the antenna 5 may be effectively reduced.

In some embodiments, when only the through slot 221 is defined in the second region 22, the heat dissipation plate 2 may not serve as the system ground for the antenna 5. Or, the heat dissipation plate 2 may also serve as the system ground for the antenna 5. Although defining the through slot 221 may increase the current return path of the antenna 5 to some extent, it does not significantly affect the overall performance and thus will not impact the overall experience. Or, the heat dissipation plate 2 may serve as the system ground for the antenna 5, and other structural improvements may be made to shorten the current return path of the antenna 5.

In some embodiments, "the through slot 221 at least partially surrounds the first region 21 and may be located between the antenna 5 and the first region 21" may also mean: the through slot 221 extends along at least one side of the first region 21 to block the heat transmitted from the heat source device 1 to the first region 21 from being transmitted towards that at least one side. The at least one side may include the side facing the antenna 5.

In some embodiments, as shown in FIG. 10, the antenna 5 may be also at least disposed at the first short side B11 of the electronic device 100. In some embodiments, the antenna 5 may be also disposed at a position on the first long side B21 close to the first short side B11. Obviously, the antenna 5 may also be disposed at a position on the second long side B22 close to the first short side B11.

In some embodiments, the configuration of the through slot 221 may refer to related contents in any of the foregoing embodiments of the present disclosure.

As mentioned earlier and shown in FIG. 10, the electronic device 100 may include the first short side B11 and the second short side B12 opposite to each other, and the first long side B21 and the second long side B22 opposite to each other. The at least one side of the first region 21 may include the side of the first region 21 facing the first short side B11. The first short side B11 may be the short side at the top of the electronic device 100, and the second short side B12 may be the short side at the bottom of the electronic device 100.

The antenna 5 may be at least disposed at the first short side B11 of the electronic device 100. In some embodiments, the antenna 5 may be also disposed at a position on the first long side B21 close to the first short side B11. Obviously, the antenna 5 may also be disposed at a position on the second long side B22 close to the first short side B11.

Obviously, in other embodiments, the heat dissipation plate 2 may be further provided with the conductive members 222 as shown in the aforementioned FIGS. 2-4 and FIG. 6, etc. The conductive members 222 may be at least electrically connected to both sides of a partial region of the through slot 221. The heat dissipation plate 2 may be the middle frame 2', serving as the system ground for the antenna 5 of the electronic device. The antenna 5 may be connected to the middle frame 2' for grounding. The through slot may be at least partially defined on the side of the first region facing the antenna 5. That is, the at least one side may include the side facing the antenna 5.

The conductive members 222 may cooperate with the through slot 221 to form a structure with a low thermal conductivity and a high electrical conductivity, to block the heat transmitted from the heat source device 1 to the first region 21 from being transmitted towards the at least one side, i.e., reducing the transmission towards the side of the antenna 5, and to effectively ensure the overall electrical conductivity integrity of the heat dissipation plate 2. When the heat dissipation plate 2 serves as the system ground for the antenna 5, for example, when the middle frame 2' is configured as the heat dissipation plate 2, the integrity of the system ground may be effectively guaranteed, reducing the possibility of lengthening the current return path of the antenna and ensuring the antenna performance.

When the heat dissipation plate 2 is further provided with the conductive members 222, the conductive members 222 may be the conductive member 222 in any of the foregoing embodiments of the present disclosure. More contents may be found in the foregoing description.

In other embodiments, when the heat dissipation plate 2 is the middle frame 2', the electronic device 100 may similarly further include a mainboard 4. The heat source device 1 may be disposed on the mainboard 4. For example, the heat source device 1 may be disposed on the surface 11 of the mainboard 4 facing the middle frame 2'. Or, the mainboard 4 may define a receiving hole (not shown), the heat source device 1 may be embedded in the receiving hole, and at least part of the heat source device 1 may protrude from the mainboard 4 towards the middle frame 2'.

The processor may be an SoC (System on Chip), a digital signal processor, a central processing unit, a microcontroller, etc.

The electronic device 100 of the present disclosure may be a mobile phone, a tablet computer, or other electronic devices including an antenna. The electronic device 100 may also include other components, which are not described further as they are unrelated to the improvement of the present disclosure.

In some embodiments, the present disclosure also provides the heat dissipation plate 2 in any of the foregoing embodiments. The heat dissipation plate 2 may be applied to or configured in the aforementioned electronic device 100 or to other devices, such as digital cameras, vehicles, etc. That is, the heat dissipation plate 2 of some embodiments of the present disclosure may be applied to or configured in any device as needed.

By using the heat dissipation plate 2, effective thermal insulating may be achieved in the side direction where heat propagation needs to be blocked, allowing heat to be conducted only towards other permitted sides. In this way, the direction of heat dissipation may be controlled, satisfying heat dissipation needs while reducing the occurrence of an excessive temperature on the at least one side that needs to be blocked.

In some embodiments, when the heat dissipation plate 2 is applied to the electronic device 100 such as a mobile phone or a tablet, the heat dissipation plate 2 may be the middle frame of the electronic device 100, serving as the system ground for the antenna of the electronic device 100. The heat dissipation plate 2 may be configured to be connected to the antenna so that the antenna may be grounded. More contents may be found in the foregoing relevant description.

In the above embodiments, the descriptions of the various embodiments have their own emphases. For parts not detailed in a certain embodiment, reference may be made to the relevant descriptions in other embodiments.

In the heat dissipation plate 2 and the electronic device 100 of some embodiments of the present disclosure, by defining the through slot 221 in the second region and the through slot 221 at least partially surrounding the first region 21, the heat conducted from the heat source device 1 to the first region 21 may be effectively blocked from continuing to be conducted in certain directions. This may reduce the possibility of heat conduction towards certain directions where conduction is undesirable, for example, avoiding or reducing heat conduction to the housing of the electronic device, thereby reducing the occurrence of issues such as the burning sensation. Furthermore, in some embodiments of the present disclosure, by adding the conductive members 222 to be at least electrically connected to both sides of the partial region of the through slot 221, the overall electrical conductivity integrity of the heat dissipation plate 2 may be effectively ensured.

The above descriptions describe only some embodiments of the present disclosure. However, the protection scope of some embodiments of the present disclosure are not limited thereto. Those skilled in the art may easily think of changes or substitutions within the technical scope disclosed in the present disclosure, which should be covered within the protection scope of the present disclosure. In the case of no conflict, the embodiments of the present disclosure and the features in the embodiments may be combined with each other, mutually referenced for explanation, or replaced. Therefore, the protection scope of the present disclosure shall be subject to the protection scope of the claims.

## Claims

1. An electronic device, comprising:
a heat source device; and
a heat dissipation plate, comprising a first region and a second region, wherein the first region is a region corresponding to a projection of the heat source device onto the heat dissipation plate, the second region is a region outside the first region, a through slot is defined in the second region, and the through slot at least partially surrounds the first region; and wherein the heat dissipation plate further comprises one or more conductive members, each of the one or more conductive members is at least electrically connected to both sides of a partial region of the through slot.

2. The electronic device as claimed in claim 1, wherein the through slot is located on at least one side of the first region and extends along the at least one side of the first region, and each of the one or more conductive members cooperates with the through slot to form a structure having a low thermal conductivity and a high electrical conductivity, and the through slot is configured to block heat, which is transmitted from the heat source device to the first region, from being transmitted towards the at least one side.

3. The electronic device as claimed in claim 2, wherein the number of the one or more conductive members is at least one, the at least one conductive member is arranged at intervals along an extension direction of the through slot, and each of the at least one conductive member bridges the both sides of the through slot and is electrically connected to the both sides of the through slot.

4. The electronic device as claimed in claim 2, wherein the one or more conductive members are filled in the through slot and are at least electrically connected to the both sides of the partial region of the through slot.

5. The electronic device as claimed in claim 4, wherein the one or more conductive members are completely filled in the through slot and electrically connected to the both sides of the through slot, a thermal conductivity of each of the one or more conductive members is less than a preset thermal conductivity, and an electrical conductivity of each of the one or more conductive members is greater than or equal to a preset electrical conductivity.

6. The electronic device as claimed in claim 5, wherein the preset thermal conductivity is 109 W/m·K, and the preset electrical conductivity is 18 S/m.

7. The electronic device as claimed in claim 4, wherein the one or more conductive members are filled in the partial region of the through slot and are electrically connected to the both sides of the partial region of the through slot.

8. The electronic device as claimed in claim 2, wherein the electronic device comprises a first short side and a second short side opposite to each other, and a first long side and a second long side opposite to each other, and the at least one side of the first region comprises a side of the first region facing the first short side.

9. The electronic device as claimed in claim 2, wherein the electronic device further comprises an antenna, the at least one side comprises a side facing the antenna, the heat dissipation plate serves as a system ground for the antenna of the electronic device, and the heat dissipation plate is configured to be connected to the antenna to ground the antenna.

10. The electronic device as claimed in any one of claims 2-9, wherein the electronic device further comprises a mainboard, the heat dissipation plate is a middle frame, and the heat source device is disposed on a surface of the mainboard facing the middle frame.

11. The electronic device as claimed in any one of claims 2-9, wherein the electronic device further comprises a mainboard, the heat dissipation plate is a middle frame, the mainboard defines a receiving hole, the heat source device is embedded in the receiving hole, and at least part of the heat source device protrudes from the mainboard towards the middle frame.

12. A heat dissipation plate for an electronic device, the heat dissipation plate comprising:
a first region, wherein the first region is a region corresponding to a projection of a heat source device of the electronic device onto the heat dissipation plate;
a second region, wherein the second region is a region outside the first region, a through slot is defined in the second region, and the through slot at least partially surrounds the first region; and
one or more conductive members, wherein each of the one or more conductive members is at least electrically connected to both sides of a partial region of the through slot.

13. The heat dissipation plate as claimed in claim 12, wherein the through slot is located on at least one side of the first region and extends along the at least one side of the first region, and each of the one or more conductive members cooperates with the through slot to form a structure having a low thermal conductivity and a high electrical conductivity, and the through slot is configured to block heat, which is transmitted from the heat source device to the first region, from being transmitted towards the at least one side.

14. The heat dissipation plate as claimed in claim 13, wherein the number of the one or more conductive members is at least one, the at least one conductive member is arranged at intervals along an extension direction of the through slot, and each of the at least one conductive member bridges the both sides of the through slot and is electrically connected to the both sides of the through slot.

15. The heat dissipation plate as claimed in claim 13, wherein the one or more conductive members are filled in the through slot and are at least electrically connected to the both sides of the partial region of the through slot.

16. The heat dissipation plate as claimed in claim 15, wherein the one or more conductive members are completely filled in the through slot and electrically connected to the both sides of the through slot, a thermal conductivity of each of the one or more conductive members is less than a preset thermal conductivity, and an electrical conductivity of each of the one or more conductive members is greater than or equal to a preset electrical conductivity.

17. The heat dissipation plate as claimed in claim 16, wherein the preset thermal conductivity is 109 W/m·K, and the preset electrical conductivity is 18 S/m.

18. The heat dissipation plate as claimed in claim 15, wherein the one or more conductive members are filled in the partial region of the through slot and are electrically connected to the both sides of the partial region of the through slot.

19. The heat dissipation plate as claimed in any one of claims 12-18, wherein the heat dissipation plate is a middle frame of the electronic device, configured as a system ground for an antenna of the electronic device, and configured to be connected to the antenna to ground the antenna, and the through slot is at least partially defined on a side of the first region facing the antenna.

20. An electronic device, **characterized by** comprising:
an antenna;
a heat source device; and
a heat dissipation plate, comprising a first region and a second region, wherein the first region is a region corresponding to a projection of the heat source device onto the heat dissipation plate, the second region is a region outside the first region, a through slot is defined in the second region, the through slot at least partially surrounds the first region and is located between the antenna and the first region.
